# EUROPEAN PATENT APPLICATION

(11) **EP 1 967 606 A1**
(43) Date of publication of application: **10.09.2008**
(21) Application number: 07004794.9
(22) Date of filing: 08.03.2007
(51) Int. Cl.: C23C 14/24, C23C 14/26

(54) **Evaporation crucible and evaporation apparatus with adapted evaporation characteristic**

(71) Applicant: Applied Materials, Inc., Santa Clara, CA 95054 (US)
(72) Inventor: Aulbach, Holger, 63801 Kleinostheim (DE); Grimm, Helmut, 64291 Darmstadt (DE)
(74) Representative: Zimmermann, Gerd Heinrich

(57) **Abstract**

An evaporation crucible is described. The evaporation crucible (100; 300; 400; 500) includes: an electrically conductive body (120) and a cover (150; 550); the body having a first electrical connection (162) and a second electrical connection (164) for applying a heating current through the body, the body includes a chamber (130) providing a melting-evaporation area, the chamber including a chamber bottom and a chamber wall, wherein the cover forms an enclosure with the chamber; a feeding opening (134; 430) for feeding a material; and a distributor orifice (170; 571, 572) providing a vapor outlet of the enclosure.

## Description

### FIELD OF THE INVENTION

The invention generally relates to thin-film forming apparatuses and crucibles used in apparatuses for thin film forming. Particularly, it relates to crucibles for evaporation of alloys or metals. Specifically it relates to an evaporation crucible and to an evaporation apparatus.

### BACKGROUND OF THE INVENTION

For thin-film coating of a material on a substrate, an evaporator can be used. For example, coatings with metal films, which e.g. provide a capacitor of a large panel display or a protective layer on a web, can be applied with evaporators. Specifically, for large panel displays, a substrate, which can be provided as a large and relatively thin glass plate, might be vertically positioned in a coating process and coated with a vertical evaporator.

Particularly for vertical evaporation, a source for a material vapor to be deposited on a substrate is commonly provided with a vertical nozzle pipe, which defines a linear vertically extending source for coating a virtually aligned substrate.

The linear sources provided thereby have a high complexity and are expensive to manufacture and to maintain. Additionally, the vertically extending nozzle pipe provides a substantial thermal irradiation towards the substrate.

Additionally, different temperature areas, which have been suggested for evaporation crucibles, can have an insufficient stability because the material to be evaporated can migrate in various areas of a crucible and can also dissolve portions of the crucible, whereby a temperature customization can be deteriorated.

### SUMMARY OF THE INVENTION

In light of the above, the present invention provides an evaporation crucible according to independent claims 1 and 3, and an evaporation apparatus according to claim 19.

According to one embodiment, an evaporation crucible is provided. The evaporation crucible includes: an electrically conductive body and a cover; the body having a first electrical connection and a second electrical connection for applying a heating current through the body, the body includes a chamber providing a melting-evaporation area, the chamber including a chamber bottom and a chamber wall, wherein the cover forms an enclosure with the chamber. The evaporation crucible further includes: a feeding opening for feeding a material; and a distributor orifice providing a vapor outlet of the enclosure.

According to another embodiment, an evaporation crucible is provided. The evaporation crucible includes: an electrically conductive body having a first electrical connection and a second electrical connection for applying a heating current through the body, the body includes a chamber providing a melting-evaporation area, the chamber including a chamber bottom and a chamber wall. The evaporation crucible further includes: a first and a second heating portion provided adjacent to the chamber and between the chamber and the first and second electrical connection, respectively; and a feeding opening for feeding a material.

According to a further embodiment, an evaporation apparatus including at least one evaporation crucible is provided. The evaporation crucible includes: an electrically conductive body and a cover; the body having a first electrical connection and a second electrical connection for applying a heating current through the body, the body includes a chamber providing a melting-evaporation area, the chamber including a chamber bottom and a chamber wall, wherein the cover forms an enclosure with the chamber. The evaporation crucible further includes: a feeding opening for feeding a material; and a distributor orifice providing a vapor outlet of the enclosure.

Further advantages, features, aspects and details that can be combined with the above embodiments are evident from the dependent claims, the description and the drawings.

Embodiments are also directed to apparatuses for carrying out the disclosed methods and including apparatus parts for performing the described method steps. These method steps may be performed by way of hardware components, a computer programmed by appropriate software, by any combination of the two or in any other manner. Furthermore, embodiments are also directed to methods by which the described apparatus operates or by which the described apparatus is manufactured. It includes method steps for carrying out functions of the apparatus or manufacturing parts of the apparatus.

### BRIEF DESCRIPTION OF THE DRAWINGS

Some of the above indicated and other more detailed aspects of the invention will be described in the following description and partially illustrated with reference to the figures. Therein:

Fig. 1a shows a schematic view of the body of an evaporation crucible including a pot-shaped chamber according to embodiments described herein; and

Fig. 1b shows a further schematic view of the evaporation crucible of Fig. 1a including a cover;

Figs. 2A to 2D show cross-sections of a body of an evaporation crucible according to embodiments described herein;

Fig. 3 shows a schematic view of a further evaporation crucible including a body and a feeding bushing according to embodiments described herein;

Fig. 4a shows a schematic side view of an even further evaporation crucible including the body and a feeding opening according to embodiments described herein;

Fig. 4b shows a schematic top view of the evaporation crucible shown in Fig. 4a;

Fig. 5 shows a schematic view of an evaporation crucible including a body, a cover and several vapor distributor orifices according to embodiments described herein;

Fig. 6 shows a schematic view of components of an evaporation apparatus for vapor deposition of a thin film on a substrate according to embodiments described herein; and

Fig. 7 shows a schematic view of components of a further evaporation apparatus according to embodiments described herein.

### DETAILED DESCRIPTION OF THE DRAWINGS

Without limiting the scope of the present application, in the following aluminum is mainly described as a material to be deposited on a substrate. The invention is also directed to metals, alloys or other materials to be evaporated and, e.g., used for the coating of a substrate. Further, without limiting the scope of the present invention, a substrate is typically referred to as a glass substrate as often used for display technology, e.g., TFT displays. Embodiments of the present invention can be applied to thin-film vapor deposition on other substrates and for other technologies.

Within the following description of the drawings, the same reference numbers refer to the same components. Generally, only the differences with respect to the individual embodiments are described.

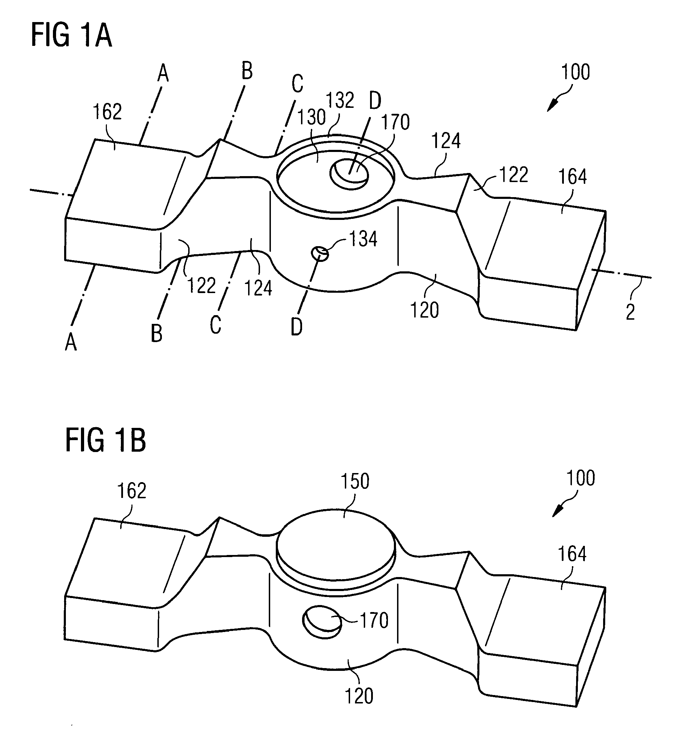

Fig. 1a shows the body 120 of an evaporation crucible 100. The body 120 includes a first electrical connection 162 and a second electrical connection 164. Between the two electrical connections a chamber 130 is provided. According to one embodiment, the chamber 130 is pot-shaped and can, for example, have a substantially cylindrical form including chamber wall 132.

The chamber further includes a chamber bottom (not shown). Further, different body regions 122 and 124 can be provided between chamber 130 and the electrical connections, through which a current is provided for heating the evaporation crucible.

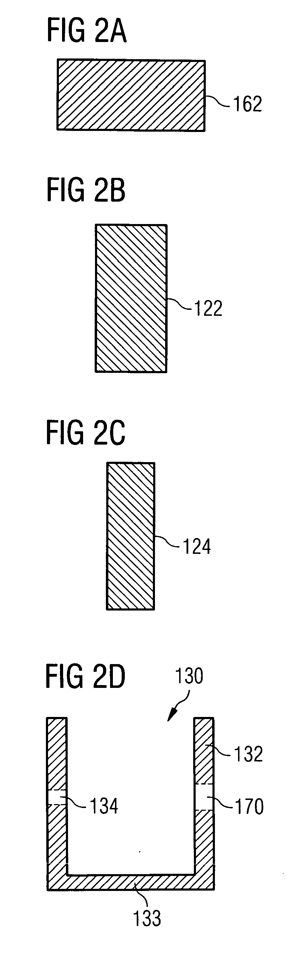

The regions, which will be described in more detail with respect to Figs. 2A to 2D, are shaped to control the current flow and, thereby, the heat generation of the body 120 of the evaporation crucible 100.

The material to be deposited is melted and evaporated by heating the evaporator crucible 100. Heating can be conducted by providing a power source (not shown) connected to the first electrical connection 162 and the second electrical connection 164. Thereby, heating is conducted by the current flowing through the body 120 of the crucible 100. Generally, within the regions having a smaller cross-sectional area, the resistance of the body is increased. Thereby, the heating power can be calculated according to equation P=R I², wherein P is the power, R is the resistance and I is the current. As a result of the proportion between the resistance and the cross-sectional area, the temperature is increased in regions having a smaller cross-sectional area. Thus, it is possible to control the resistances of the different areas of the crucible such that desired temperatures are provided in the different areas. For example, the temperature in the melting-evaporation area in the chamber 130 can be in the range of 700°C to 1600°C or 1300°C-1600°C.

According to further embodiments, the resistance of different areas of the evaporator crucible 100 can further be controlled by changing the material composition of the evaporator crucible body 120

Generally, according to embodiments described herein, the materials of the crucible should be conductive, temperature resistant to the temperatures used for melting and evaporating the materials, and should be resistant with regard to the liquid materials or the material vapor, respectively. For example, liquid aluminum is highly reactive and can provide significant damage to crucibles for melting aluminum. According thereto, typically, materials selected from the group consisting of a metallic boride, a metallic nitride, a metallic carbide, a non-metallic boride, a non-metallic nitride, a non-metallic carbide, nitrides, borides, graphite, and combinations thereof can be used (e.g., TiB₂, a combination of TiB₂ and AIN, a combination of TiB₂ and BN, or a combination of TiB₂, BN and AIN).

The difference in electrical resistivity of these materials can be used to further adapt the heat generation in the crucible. Thereby, the material composition in the different regions of the body can be chosen to have a corresponding resistivity depending on the desired heat generation in the respective regions.

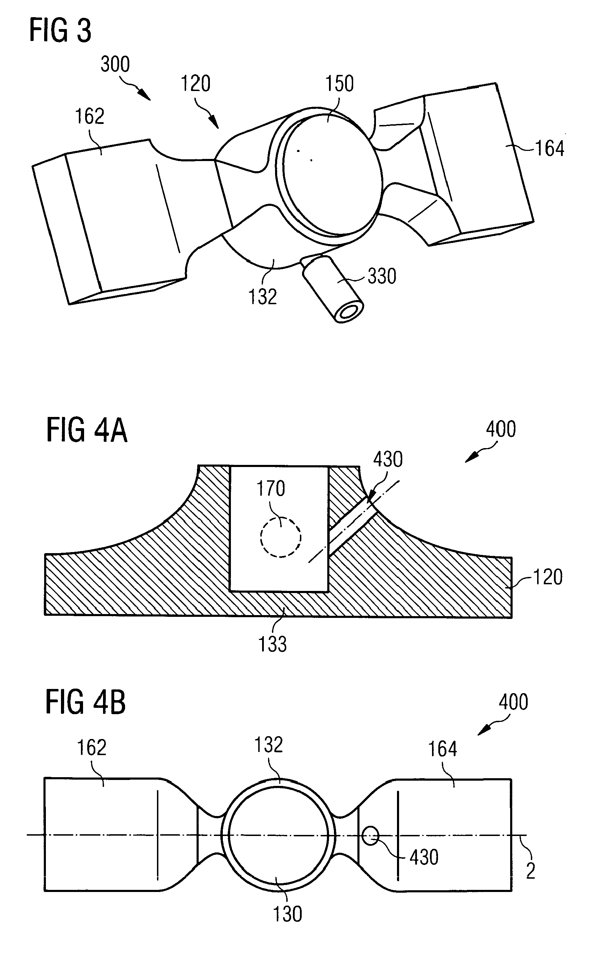

In Figs. 1a and 1b, the chamber 130 has an opening 130 for feeding a wire of the material to be evaporated. The opening 130 is provided in a chamber wall. According to one embodiment, the opening 130 is provided on an axis of the body 120 that is substantially perpendicular to the axis 2 of the body defined by the positions of the first electrical connection 162 and the second electrical connection 164. According to another embodiment, the opening 130 for feeding the wire in the chamber 130 can also be provided close to or on an axis 2 defined by the positions of the first electrical connection and a second electrical connections (see, e.g. Figs. 4a and 4b).

According to further embodiments, which can be yielded by a combination with any of the embodiments described herein, a feeding of the material can be provided by a wire. Additionally or alternatively, the material can be fed in the evaporation crucible by pellets or the like.

According to even further embodiments (not shown), the opening 134 feeding the wire of the material to be evaporated and deposited on a substrate, may also be provided in the cover 150. The cover 150, which is shown in Fig. 1b, and the chamber 130 provide an enclosure with a melting-evaporation area.

According to embodiments described herein, the melting-evaporation area is closed to a maximum degree. Thus, the amount of vapor leaving the chamber in an undesired direction (e.g., in direction of the opening for feeding the material) can be minimized.

As an example, the temperature in the melting-heating area of the chamber 130 is above the evaporation temperature of the material to be deposited. However, a wire provided for feeding the material results in a local decrease in the temperature in a small portion of the melting-evaporation area. According to further embodiments, the temperature is at least 200°C above the evaporation temperature, e.g., 200°C to 900 °C or 600°C to 870 °C above the evaporation temperature. For example, for aluminum, the temperature can be above 900°C or above 1150 °C.

Typically, a lower limit of the temperature depends on the melting temperature of the material to be deposited and the chamber pressure. Typically, an upper limit of the temperature can be given by the temperature stability of the evaporation crucible.

As shown in Fig. 1a, according to embodiments described herein, chamber wall 132 of chamber 130 can have a distributor orifice 170 through which the material vapor may leave the enclosure with a defined evaporation direction.

Vapor deposition of thin films may, for example, be applied for organic light emitted diodes (OLED), for other display devices (e.g. TFT), or generally for thin-film coating on glass substrates or foils. As an example, thin metal films are provided for display applications in order to control individual pixels of a display.

Typically, for applications providing a vapor deposition for vertically arranged substrates, a linear evaporator unit with a nozzle pipe, which redirects vapor emitted by an evaporation area of an elongated crucible, can be used. Thereby, the vertically arranged substrate can be transported past the linear evaporation apparatus in a horizontal direction for thin film coating of the substrate. However, the nozzle pipe for redirecting the material vapor along horizontal evaporation axes and the commonly used crucibles are complex and difficult to maintain. Since vertical substrate arrangement is desired in light of particle contamination and bending of the substrates, it is desirable to have simplified evaporation sources for vertical evaporation applications. Embodiments of evaporation crucibles described herein can be used as a point source for a vertical evaporation apparatus.

As a further example, the embodiments described herein can be utilized for the coating of substrates for display technology or the like. Thereby, substrate size may be as follows. A typical glass substrate and, thereby, also a coating area can have dimensions of about 0.7 mm x 370 mm x 470 mm. Yet, next generation substrates can have a size of about 1100 mm x 1300 mm or larger. For example, applications described herein refer typically to large substrates. Thereby, a large substrate can have a height and length of 500 mm or above. This can typically be 680 mm x 880 mm, 1100 mm x 1300 mm or larger in the case of glass substrates. Typical large flexible substrates, e.g., foils, can have a width of at least 500 mm.

According to the embodiments described with respect to Figs. 1a and 1b, a cover 150 is provided on the chamber 130. Thereby, an enclosure including a melting-evaporation area is provided. The material to be evaporated, for example aluminum, is provided in the chamber through opening 130 and contacts a heated surface within the chamber. According to one embodiment, the material may be provided at the bottom of the chamber.

Within the chamber, the material is melted and upon further heating evaporated in the melting-evaporation area. The material vapor leaves the chamber through distributor orifice 170 and can thereafter be deposited on a substrate. The distributor orifice includes an evaporation axis, which is defined by the direction of the opening or the bore in the enclosure. For example, if a horizontal bore is provided in the wall of a pot-shaped chamber - the bore defining the distributor orifice - a horizontal evaporation axis is provided.

According to even further embodiments, which might be combined with other embodiments herein, a distributor orifice can be provided with a channel length of 2 to 10 mm along the evaporation axis. According to even further embodiments, the diameter of the orifice is in the range of 3 to 20 mm.

As describe above, the chamber can be pot-shaped. According to further embodiments, the chamber has substantially the same dimension along axis 2 and an axis perpendicular thereto and/or the same dimensions along two perpendicular directions along the bottom of the chamber, a dimension can, according to even further embodiments, be in the range of 20 mm to 150 mm or typically 30 mm to 50 mm. According to another embodiment, the height can be in the range of 20 mm to 50 mm or typically 25 mm to 40 mm. According to yet further embodiments, the chamber is a circular or elliptical cylinder. This shape can provide an improved stability and/or volume-surface ratio.

According to embodiments described herein, the melting-evaporation area is to be understood as an area in which the material to be evaporated is melted and evaporated. Thereby, a one chamber system with similar pressure conditions within the chamber can be provided. Additionally or alternatively, other separation means for separating a melting area and an evaporation area within the chamber might, according to embodiments described herein, be omitted. Accordingly, problems with migration of the very thin liquid material films or problems with a timely variation of customized temperature profiles in light of dissolving of portions of the evaporation crucible can be prevented.

According to embodiments described herein, the melting zone (e.g., a surface) of the melting evaporation area is within the evaporation zone.

A melting zone within the evaporation zone can e.g., be understood as having a reduced gas pressure region within the evaporation zone, for example in the range of 10% or 20%, in the melting-evaporation-area.

A melting zone within the evaporation zone can, as another example, be understood as having the melting zone (e.g., a surface) within the main evaporation zone, that is, for example, the zone in which at least 50% or 75% of the evaporation is conducted.

Thereby, the possibility of a splashboard, a faceplate for controlling splashing or the like does not affect the functionality of the melting-evaporation area.

The evaporation crucible 100 includes a body 120 and a cover 150. If the material, for example aluminum, is provided by continuously feeding the material to be deposited with a feeding wire 102, an equilibrium can be maintained such that the amount of material in the system is substantially constant. Thereby, the amount of material inserted in the system is provided by the diameter and the feeding speed of the feeding wire 102. In order to provide an equilibrium, the amount of material which is evaporated from the evaporator crucible 100, and the amount of material fed in the system should be similar.

As shown in Figs. 1a and 1b, a cover 150 is provided on an upper portion of the chamber wall 132. According to one embodiment, it is possible to provide the cover 150 such that the cover is centered with respect to the chamber 130 at an inner portion of the chamber wall 132. According to further embodiments, the cover 150 can, thereby, have a lid extending outwardly upon the upper edge of the chamber 130 or can be provided within a recess of the chamber wall. According to an even further embodiment, the cover 150 may be centered with respect to the chamber 130 by an outer portion of the chamber wall 132.

According to one embodiment, the cover 150 can be made of the non-conductive material. Thereby, it may include BN, or the like. A non-conductive cover is passively heated by the adjacent portion of the body.

In light of the size of the chamber 130 and the heating portions 124 of the body 120 (see, e.g., Figs. 2A to 2D), the cover 150 can be sufficiently heated such that there is hardly any condensation of vapor at the cover. Thereby, migration of liquid material in the contact region of the chamber and the cover can be prevented. Further, the sufficiently heated cover 152 together with the distributor orifice 170 provides a melting-evaporation area such that the evaporated material is mainly influenced by the distributor orifice. The vapor leaves the chamber via the orifice. The presence of the cover is hardly experienced by the material vapor. The cover 150 allows a vertical arrangement of a plurality of evaporation crucibles 100, whereby a vertical evaporation apparatus including several point source units can be realized.

According to embodiments described herein, the shape of the body of an evaporation crucible can be designed to have different cross-sections as shown in Figs. 2A to 2D. Fig. 2A shows a cross-section in the area of the electrical connections 162 or 164. The cross-section is indicated by section A-A in Fig. 1a. Fig. 2B shows a cross-section at the section B-B in Fig. 1a. The cross-sectional area at the region 122 can be similar to the cross-sectional area at the electrical connection 162. However, the cross-section 122 has been converted from a horizontally flat shape to a vertical shape. Thus, according to another embodiment, a cross-section shape transforming portion can be provided as a portion of the body on one or both sides of the chamber. The cross-section shape transforming portion is an intermediate electrically conductive area with a modified cross-section. Thereby, the current flow of a heating current through the body 120 is transformed such that the current flows substantially at the entire height of the body and, thus, the chamber 130. According to another embodiment, the cross-section shape of a cross-section shape transforming portion can be at least 80 % or 90 % of the chamber height. As an example, for embodiments described herein, the cross-section shape transforming area of the body can be provided between an electrical connection of the body and a heating portion of the body, which is described below, or a chamber of the body. Additionally, according yet further embodiments, the cross-section shape transforming portion and/or the transition from the electrical connection to the cross-section shape transforming portion can be cross-section area conserving.

A heating of the chamber 130 mainly along the entire height of the chamber reduces temperature gradients that may result in cracking of the evaporation crucible. Further, the cover provided on the top portion of the chamber can be heated to substantially the same temperature as the chamber itself. Thereby, condensation and resulting migration of resulting liquid material can be prevented.

Fig. 2C shows the cross-section at the portion 124. The portion 124 is a heating portion which is provided between the electrical connection and the chamber. This heating portion is adjacent to the chamber. As shown in Fig. 2C, the heating portion 124 can be provided by reducing the cross-sectional area and/or the resistivity in this region of the body by about 5 % to 20%. According to a further embodiment, the heating portion can be provided at a higher temperature as compared to the electrical connection by cooling the area of the electrical connection. Thereby, the electrical connection provides a heat sink in light of, e.g., cooled connecting elements of an evaporation apparatus. The connection elements of the evaporation apparatus can for example be a clamp unit. Accordingly, a higher temperature region at the heating portion is provided adjacent to the chamber in light of the distance to the heat sink. According to yet another embodiment, the heating portion 124 can be provided by having a heat sink at the electrical connection 162 and by the slightly reduced cross-sectional area. The cross-section shown in Fig. 2C also has a vertical elongation to continue the current flow provided by a cross-section of Fig. 2B towards the chamber of the body. Thus, according to different embodiments: A heating portion 124 of the body can be provided on one or both sides of the chamber, adjacent to the chamber and located between the chamber and a respective one of the electrical connections. Additionally or alternatively, the heating portion can have a higher resistance than the electrical connection, e.g., due to the cross-sectional area and/or the material resistivity.

The cross-section of the chamber 130 including the chamber wall 132 and the chamber bottom 133 is shown in Fig. 2D. Fig. 2D illustrates an opening for feeding a material to be evaporated and a distributor orifice 170. The cross-sectional area of the chamber is similarly or slightly smaller than the cross-section of the heating portion 124. For example, the cross-sectional area and/or the resistivity of the chamber can be 0% to 20% smaller than the cross-sectional area and/or the resistivity of the heating portion 124 shown in Fig. 2C. By providing a heating portion on both sides of the chamber, a better heating symmetry of the chamber and the melting-evaporation area can be provided.

The heating portions on both sides and adjacent to the chamber provide an improved symmetric heating as compared to only locally heating the chamber. By providing a heat generation in the chamber that is not extensive as compared to the heat generation in the adjacent heating portions 124 results in a more homogeneous temperature within the chamber and, thereby, the melting-evaporation area.

Additionally, according to further embodiments described herein, the electrical connections 162, the region 122 and the region 124 together, have a length in the range of 80 mm to 220 mm. Thereby, a transition from comparably cold regions at the electrical connections to the comparable high temperature regions in and adjacent to the chamber can be provided.

According to different embodiments that might be combined with any of the embodiments described herein, the electrical connections may be provided at the body by protrusions of the main body. Thereby, the protrusions can be formed to be contacted by contact elements of the evaporation apparatus. Additionally, the contact elements of the evaporation apparatus can be cooled. Generally, the electrical contacts are provided for applying a heating current through the body. The current is thereby applied by a power source of the evaporation apparatus.

A further evaporation crucible 300, which can also be used as a point source for vertical evaporation apparatuses, is shown in Fig. 3. The crucible 300 includes a first electrical connection 162 and a second electrical connection 164. The chamber of the body 120 is covered by the cover 150. Within one chamber wall 132, an opening for introducing a wire for feeding the material to be evaporated is provided. Within the opening a bushing 330 is provided to insert the wire in the chamber through the bushing.

According to one embodiment, which can be combined with the bushing or which can be provided separately, the opening in the chamber wall 132 is inclined with respect to the chamber wall. Thereby, the wire can be inserted towards the bottom of the chamber. According to an even further embodiment, the opening in the chamber wall is provided with a chamfered edge. As shown in Figs. 4a and 4b, an opening 430 may also be provided in a portion of the body that is adjacent to the chamber. Thereby, and opening in the chamber wall which is at or near axis 2 is provided. According to yet another embodiment (not shown), an opening for introducing the feeding wire may be provided in a cover.

Fig. 4a shows the body 120 of crucible 400. The material wire for feeding the material to be evaporated can be provided at or close to axis 2. The body 120 includes chamber 130 having a chamber wall 132 and a chamber bottom 133. As indicated in Fig. 4a, a distributor orifice 170 is provided in a wall 132 of the chamber 130. According to a further embodiment, the arrangement shown in Fig. 4 can also be provided with a bushing described with respect to Fig. 3.

According to the embodiments described herein, the distributor orifice 170 provided in the wall of the chamber 130 provides a vapor orifice with a directional evaporation axis. The distributor orifice includes an evaporation axis, which is defined by the by the direction of the opening or the bore in the enclosure. For example, if a horizontal bore is provided in the wall of a pot-shaped chamber - the bore defining the distributor orifice - a horizontal evaporation axis is provided.

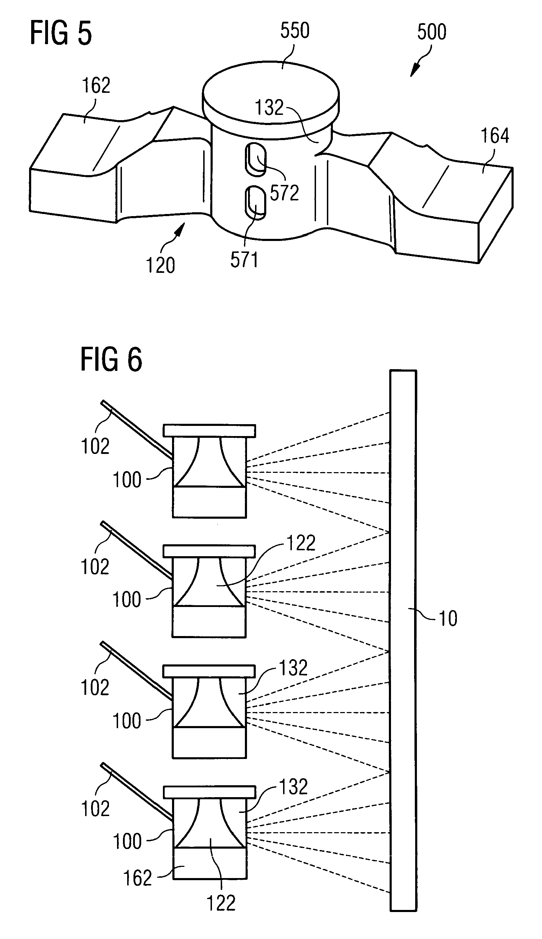

Thereby, an evaporation distribution is provided by the distributor orifice. The distribution of evaporation can be defined by the bore or the opening in the chamber. Accordingly, the distribution can be adapted by the shape, the diameter, and by the length of the distributor orifice. For example, the wall thickness can define a length of the distributor orifice along the directional evaporation axis of the orifice. According to different embodiments, the shape of the distributor orifice can be round, oval, elliptical, angular, cylindrical, slit shaped, or formed in another way. According to yet another embodiment, which might be combined therewith, the direction of the evaporation axis can be horizontal or inclined with respect to the chamber wall surface. Further, it is additionally or alternatively possible to have the edges of the bore chamfered. According to yet further embodiments, as for example shown in Fig. 5, an evaporation crucible 500 can be provided with a first distributor orifice 571 and the second distributor orifice 572. Within Fig. 5, the distributor orifices have an elongated oval shape with the elongated axis being vertical. As shown in Fig. 5, the chamber of the body 120 having the first electrical connection and the second electrical connection 164 can be covered with a cover 550 that is centered by outer portion of the chamber wall 132.

According to even further embodiments, which might be combined with other embodiments herein, a distributor orifice can be provided with a channel length of 2 to 10 mm along the evaporation axis. According to even further embodiments, the diameter of the orifice is in the range of 3 to 20 mm.

Components of an evaporation apparatus having a plurality of vertically arranged evaporation crucibles 100 is shown in Fig. 6. As an exemplary embodiment, a method of forming a thin film with an evaporation crucible described herein can be carried out by using an apparatus which is entirely placed in a vacuum atmosphere of 10⁻² -10⁻⁶ mbar. Thereby, the thin film can be vapor deposited on a substrate or a carrier foil without contamination of particles from ambient atmosphere.

According to embodiments described herein, a method of evaporating a material includes: providing a chamber with a melting-evaporation area, and inserting a solid material to be evaporated in the melting-evaporation area.

In Fig. 6, four evaporation crucibles 100 are vertically arranged one above the other. This is, for example, possible in light of the covers provided on the evaporation crucible. In the side view provided in Fig. 6, the electrical connections 162, a portion 122 of the body and a portion of the chamber wall 132 can be seen. The wires 102 for feeding the material to be evaporated are inserted in the chamber for melting and evaporating the wire material.

Typically, the evaporation crucibles 100 are arranged such that the vapor distributions of the individual crucibles overlap such that a substantially homogenous vapor deposition on the substrate 10 is provided. According to one embodiment, the shape of the distributor orifices may be optimized for the combined vapor distribution of neighboring evaporation crucibles. As shown in Fig. 6, a vertical evaporation apparatus with several point sources for a material paper can be provided with evaporation crucibles according to the embodiments described herein.

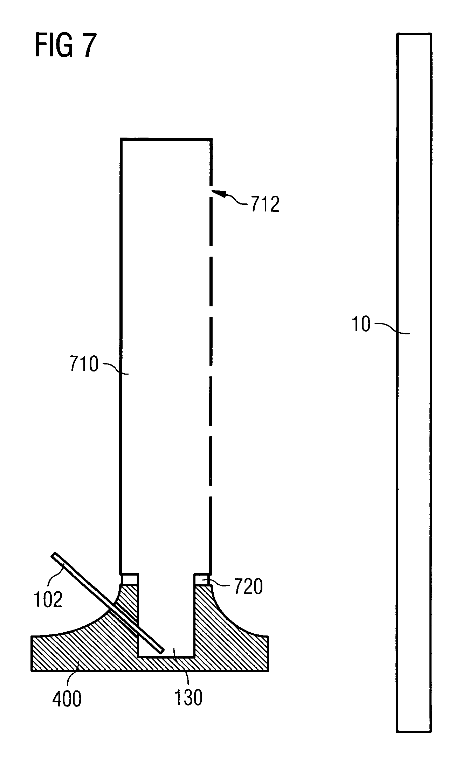

A further evaporation apparatus that can be realized with an evaporation crucible 400 according to embodiments described herein is shown in Fig. 7. Thereby, a material film is to be vapor deposited on a vertically arranged substrate 10. Therefore, an evaporation crucible 400 is provided in a lower portion of the evaporation apparatus. Fig. 7 shows a material wire 102 for feeding the material to be evaporated in the evaporation crucible. Within the chamber 130, the material is melted and evaporated in the melting-evaporation area. The material vapor can leave the chamber at the top of the chamber and passes through the insulation element 720 in the nozzle pipe 710. The nozzle pipe 710 includes a plurality of openings 712 and redirects the material vapor along horizontal axes towards the substrate 10. The nozzle pipe 710 may be made of a high melting material such as titanium, niobium, tungsten, or an alloy including one of these materials and can be manufactured as commonly known in the art. According thereto, different embodiments of evaporation crucible as described herein can be used for a linear evaporation apparatus with a nozzle pipe. Thereby, the improved melting-heating chamber according to embodiments described herein can be provided for existing systems.

While the foregoing is directed to embodiments of the invention, other and further embodiments of the invention may be devised without departing from the basic scope thereof, and the scope thereof is determined by the claims that follow.

## Claims

1. Evaporation crucible (100; 300; 400; 500) comprising:
an electrically conductive body (120) and a cover (150; 550);
the body having a first electrical connection (162) and a second electrical connection (164) for applying a heating current through the body, the body comprises a chamber (130) providing a melting-evaporation area, the chamber comprising a chamber bottom and a chamber wall, wherein the cover forms an enclosure with the chamber;
a feeding opening (134; 430) for feeding a material; and
a distributor orifice (170; 571, 572) providing a vapor outlet of the enclosure.

2. Evaporation crucible according to claim 1, further comprising:
a first and a second heating portion (124) provided adjacent to the chamber and between the chamber and the first and second electrical connection, respectively, wherein the heating portions have a higher resistance than the electrical connections (162, 164).

3. Evaporation crucible comprising:
an electrically conductive body (120) having a first electrical connection (162) and a second electrical connection (164) for applying a heating current through the body, the body comprises a chamber (130) providing a melting-evaporation area, the chamber comprising a chamber bottom and a chamber wall;
a first and a second heating portion (124) provided adjacent to the chamber and between the chamber and the first and second electrical connection (164), respectively;
a feeding opening (134; 430) for feeding a material.

4. Evaporation crucible according to claim 3, further comprising:
a cover (150; 550) forming an enclosure with the chamber (130); and
a distributor orifice (170; 571, 572) providing a vapor outlet of the enclosure.

5. Evaporation crucible according to any of the preceding claims, wherein the first electrical connection (162) and the second electrical connection (164) provide an axis of the evaporation crucible, and wherein the chamber dimension along the axis and perpendicular to the axis is substantially similar.

6. Evaporation crucible according to any of the preceding claims, wherein the chamber is pot-shaped.

7. Evaporation crucible according to any of the preceding claims, wherein the chamber (130) is substantially cylindrical.

8. Evaporation crucible according to any of the preceding claims, wherein the distributor orifice (170; 571, 572) is provided through a chamber wall portion.

9. Evaporation crucible according to any of the preceding claims, wherein the feeding opening (134; 430) is provided through a chamber wall portion.

10. Evaporation crucible according to any of the preceding claims, wherein the heating portions (124) have a cross-sectional area smaller than the cross-sectional area of the electrical connections.

11. Evaporation crucible according to any of claims 1 and 4, wherein the first electrical connection (162) and the second electrical connection (164) provide an axis of the evaporation crucible and the distributor orifice is provided at a chamber wall portion which is off-axis with respect to the axis.

12. Evaporation crucible according to any of the preceding claims, wherein the first electrical connection and the second electrical connection provide an axis of the evaporation crucible and the feeding opening (430) is provided at a chamber wall portion on the axis.

13. Evaporation crucible according to any of the preceding claims, wherein the first electrical connection and the second electrical connection provide an axis of the evaporation crucible and the feeding opening (134) is provided at a chamber wall portion which is off-axis with respect to the axis.

14. Evaporation crucible according to any of the preceding claims, wherein the body (120) includes at least one material selected from the group consisting of: a metallic boride, a metallic nitride, a metallic carbide, a non-metallic boride, a non-metallic nitride, a non-metallic carbide, nitrides, borides, graphite, and combinations thereof.

15. Evaporation crucible according to any of the preceding claims, wherein the distributor orifice has an evaporation axis and wherein the evaporation axis is substantially horizontal.

16. Evaporation crucible according to any of the preceding claims, wherein the distributor orifice has an evaporation axis and wherein the distributor orifice has a length along the evaporator axis of 2 mm to 10 mm.

17. Evaporation crucible according to any of the preceding claims, wherein the diameter of the distributor orifice is at least 2 mm.

18. Evaporation crucible according to any of claims 1 to 2 or 4 to 17, wherein the cover (150; 550) comprises a non-conductive material.

19. An evaporation apparatus, comprising:
at least one evaporation crucible (100; 300; 400; 500) according to any of the preceding claims.

20. Evaporation apparatus according to claim 19, comprising:
at least five evaporation crucibles according to any of the preceding claims.

21. Evaporation apparatus according to claim 20, wherein the at least five evaporation crucibles are vertically aligned.
